# FASCICULE DE BREVET EUROPEEN

(11) **EP 1 017 171 B1**
(45) Date de publication et mention de la délivrance du brevet: **24.01.2007**
(21) Numéro de dépôt: 99403267.0
(22) Date de dépôt: 23.12.1999
(51) Int. Cl.: H03H 11/20, H03F 3/60

(54) **Dispositif de contrôle de phase constitué de multiples structures amplificatrices distribuées à éléments actifs commutables pour former une ligne à longueur programmable**
Phasensteuervorrichtung mit einer Vielzahl von Kettenverstärkerstrukturen mit schaltbaren aktiven Elementen zur Erstellung einer Übertragungsleitung mit programmierbarer Länge
Phase control device with a plurality of distributed amplifier structures with switchable active elements for constituting a programmable length line

(30) Priorité: 29.12.1998 FR 9816556
(43) Date de publication de la demande: 05.07.2000
(73) Titulaire: THALES SYSTEMES AEROPORTES S.A., 78990 Elancourt (FR)
(72) Inventeur: Dueme, Philippe, 91400 Orsay (FR); Millot, Philippe, 94150 Rungis (FR)
(74) Mandataire: Plaçais, Jean Yves

(56) Documents cités:
- US-A- 4 772 858
- US-A- 4 788 509
- MILITARY MICROWAVES '86 CONFERENCE PROC. 24-26 JUNE 1986, BRIGHTON, GB R.S. PENGELLY: A REVIEW OF BROADBAND MONOLITHIC MICROWAVE INTEGRATED CIRCUITS, P583-596. XP002115859

## Description

La présente invention concerne un dispositif de contrôle de phase constitué de multiples structures amplificatrices distribuées à éléments actifs commutables pour former une ligne à longueur programmable. Un dispositif similaire est connu p. ex. du document US 4 772 858.

Elle trouve une application générale en télécommunication ou en instrumentation hyperfréquence large bande (par exemple du continu jusqu'à plusieurs dizaines de GHz), et plus particulièrement dans les systèmes électroniques de type contre-mesure, balayage électronique, ou spatial. Elle appartient au domaine technique de la micro-électronique hyperfréquence, et plus particulièrement à la technologie des circuits intégrés monolithiques micro-ondes (MMIC).

Le plus souvent, un dispositif de contrôle de phase à commande numérique fonctionne sur la base d'une commutation entre au moins deux voies différentes, susceptibles chacune de se comporter soit comme un déphaseur, soit comme une ligne à longueur programmable.

En pratique, dans un déphaseur, entre deux états, le signal subit en transmission un déphasage dont la valeur est constante dans la bande de fréquences considérée. An contraire, dans une ligne de longueur programmable, entre deux états, le signal subit en transmission un déphasage dont la valeur correspond à la propagation du courant le long d'une ligne de longueur constante (c'est-à-dire un retard constant) dans la bande de fréquences considérée.

De façon connue, un dispositif de contrôle de phase comprend une entrée de commande numérique, et, entre une entrée de signal et une sortie de signal, au moins une cellule comportant des moyens de commutation aptes, sous contrôle d'un bit de l'entrée de commande, à procurer au moins deux fonctions de transfert différentes en termes de phase et/ou retard temporel.

On sait mettre en oeuvre un tel dispositif de contrôle de phase à partir d'une technologie de circuits intégrés monolithiques micro-ondes (MMIC) sur une bande de fréquences allant par exemple de 2 à 18 GHz.

Cependant, la mise en série de plusieurs cellules réalisées entièrement en technologie MMIC conduit à des pertes d'insertion relativement importantes.

En effet, un commutateur passif fonctionnant dans la bande de fréquences mentionnée ci-avant est susceptible de perdre en insertion 1 à 2 dB selon l'isolement.

De même, une cellule de déphasage ou de retard peut présenter des pertes allant jusqu'à 2 dB pour les bits de poids moyens et forts. Ainsi, la réalisation sur technologie MMIC d'une ligne à longueur programmable de 9 bits comprenant 9 cellules de même structure mises en série peut conduire à des pertes d'insertion comprises entre 30 et 40 dB.

La demanderesse s'est posée le problème de remédier à ces inconvénients.

La présente invention a justement pour but de proposer des solutions susceptibles de minimiser les pertes d'insertion dans des dispositifs de contrôle de phase du type décrit ci-avant.

La présente invention est définie dans la revendication indépendante 1.

Elle porte sur un dispositif de contrôle de phase à commande numérique, comprenant une entrée de commande numérique, et, entre une entrée de signal et une sortie de signal, au moins un circuit comportant des moyens de commutation aptes, sous contrôle d'un bit de l'entrée de commande, à procurer deux fonctions de transfert différentes en termes de phase et/ou retard temporel.

Selon un mode particulier de réalisation de l'invention, le circuit comporte au moins un double amplificateur distribué comprenant au moins une première ligne dont une extrémité forme borne commune pour les moyens de commutation, au moins des deuxième et troisième lignes dont les extrémités forment les bornes commutées pour les moyens de commutation, et, entre la première ligne et chacune des deux lignes commutées, au moins un élément actif commutable, commandé en fonction du bit de contrôle du circuit, l'élément actif commutable disposé entre la première ligne et la deuxième ligne étant polarisé en mode amplificateur lorsque l'élément actif commutable disposé entre la première ligne et la troisième ligne est polarisé bloquant, et réciproquement, l'une des extrémités de la deuxième ligne et l'une des extrémités de la troisième ligne étant reliées l'une et l'autre à un organe sommateur, ce qui permet au double amplificateur distribué de former une ligne à longueur programmable à 1 bit.

Un tel double amplificateur distribué présente l'avantage de combiner les fonctions amplification, commutation, et retard en s'affranchissant des pertes d'insertion d'un commutateur passif. Le bilan global en termes de performances et de consommation en est amélioré d'autant.

Selon un premier mode de réalisation de l'invention, l'organe sommateur est passif.

Selon un second mode de réalisation de l'invention, l'organe sommateur est actif.

Selon un troisième mode de réalisation, l'organe sommateur est formé par la mise en série des deuxième et troisième lignes du double amplificateur distribué, ledit double amplificateur distribué formant une structure auto-recombineuse.

Selon un quatrième mode de réalisation de l'invention, le double amplificateur distribué comprend au moins des première et seconde simples structures distribuées comprenant chacune une ligne de grilles commune et une ligne de drains commune, l'une des extrémités de la ligne de grilles commune de la première structure étant reliée à l'une des extrémités de la ligne de grilles commune de la seconde structure pour former la première ligne du double amplificateur distribué tandis que les lignes de drains des première et seconde structures distribuées constituent respectivement les deuxième et troisième lignes du double amplificateur distribué.

Selon un cinquième mode de réalisation de l'invention dans lequel le double amplificateur distribué est constitué au moins de deux simples structures distribuées mises en série au niveau de leurs lignes de grilles, l'une des extrémités de la deuxième ligne et l'une des extrémités de la troisième ligne sont reliées l'une et l'autre à un organe sommateur dont la sortie est reliée à une charge, les première et seconde simples structures distribuées formant ainsi une ligne à longueur programmable à 1 bit.

En pratique, le dispositif selon l'invention peut comprendre plusieurs simples structures distribuées dont les lignes de grilles communes sont mises en série directement ou indirectement pour former des lignes à longueur programmable de plusieurs bits.

D'autres caractéristiques et avantages de l'invention apparaîtront à la lumière de la description détaillée ci-après et des dessins dans lesquels :
- la figure 1 représente un dispositif de contrôle de phase à deux voies conforme à l'art antérieur;
- la figure 2 représente schématiquement la fonction équivalente réalisée par un commutateur actif;
- la figure 3 représente schématiquement le montage d'un simple amplificateur distribué conforme à l'art antérieur;
- la figure 4 illustre le montage d'un double amplificateur distribué assurant la fonction d'un commutateur actif à une entrée et deux sorties;
- la figure 5 illustre le montage d'un double amplificateur distribué assurant la fonction d'un commutateur actif à deux entrées et une sortie;
- la figure 6 illustre le montage de deux doubles amplificateurs distribués montés en série, le premier étant celui décrit en référence à la figure 4 et le second étant celui décrit en référence à la figure 5;
- la figure 7 illustre une variante de représentation schématique du montage d'un simple amplificateur distribué conforme à l'art antérieur;
- la figure 8 illustre le montage d'un commutateur actif réalisé avec deux simples amplificateurs distribués mis en série selon l'invention;
- la figure 9 représente schématiquement un commutateur actif réalisé avec 4 simples amplificateurs distribués mis en série selon l'invention;
- la figure 10 représente schématiquement une ligne à longueur programmable à 1 bit réalisé à partir de deux simples amplificateurs distribués mis en série selon l'invention;
- les figures 11 et 12 représentent des lignes à longueurs programmables à 2 bits selon l'invention;
- la figure 13 représente schématiquement une ligne à longueur programmable à 3 bits selon l'invention;
- la figure 14 représente schématiquement une ligne à longueur programmable à 4 bits selon l'invention;
- la figure 15 représente une structure à double amplificateur distribué ayant une configuration auto-recombineuse, selon l'invention; et
- la figure 16 représente une variante de la structure de la figure 15.

Les dessins comportent des éléments de caractère certain. A ce titre, ils servent à illustrer l'invention.

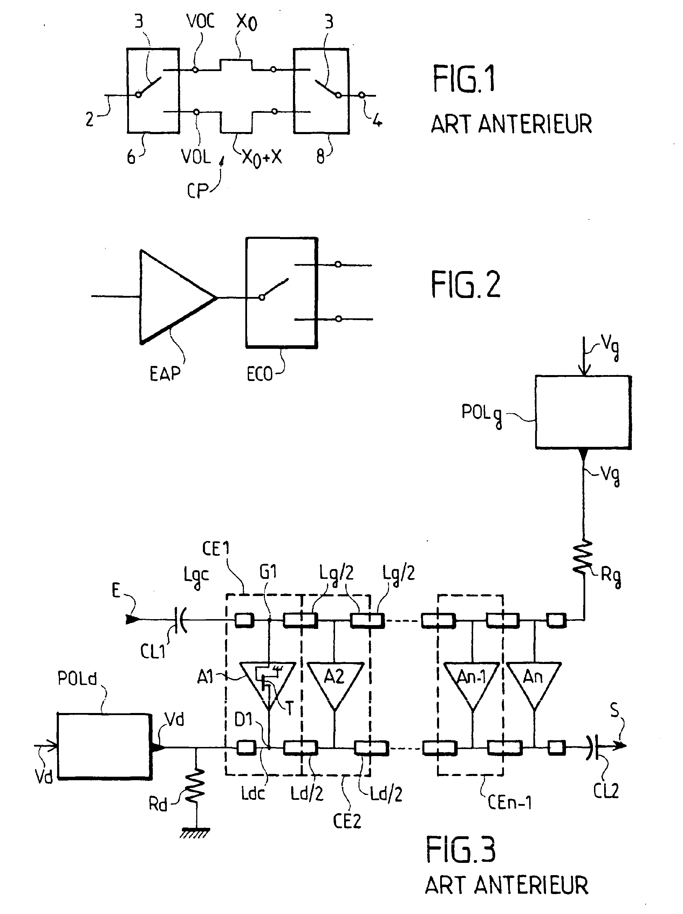

En référence à la figure 1, un dispositif de contrôle de phase CP, conforme à l'art antérieur, fonctionne sur la base d'une commutation entre au moins deux voies différentes, par exemple une voie courte VOC et une voie longue VOL. Le dispositif CP est susceptible de comprendre plusieurs étages mis en série, dont un seul est ici représenté pour alléger la description.

Le dispositif CP comprend une entrée de signal 2 et une sortie de signal 4. Un commutateur 6, ayant une entrée et deux sorties, est sous le contrôle d'un bit de l'entrée de commande 3. De même, un commutateur 8 ayant deux entrées et une sortie, est sous le contrôle d'un bit de l'entrée de commande 3. Ainsi, les commutateurs 6 et 8 sont aptes, sous contrôle d'un bit de l'entrée de commande 3, à procurer au moins deux fonctions de transfert différentes en terme de phase et/ou retard temporel.

La voie courte VOC est associée à une quantité x0 tandis que la voie longue VOL est associée à une quantité xO+x. La quantité x représente, soit un déphasage, soit une longueur électrique de ligne. Les valeurs x0, x1, x2, etc... correspondent à la phase commune entre les deux états de chaque étage. Elles n'interviennent donc pas dans le contrôle du signal. La valeur x et ses multiples égaux à une puissance de 2 correspond à la différence entre les deux états. Cette valeur x correspond également au bit de plus faible poids.

La fabrication de ce type de circuit en technologie de circuit intégré monolithique micro-onde (MMIC) sur une bande de fréquence allant, par exemple, de 2 à 18 GHz est réalisable.

Cependant, la mise en série de plusieurs étages réalisés entièrement en technologie (MMIC) conduit à des pertes d'insertion relativement importantes. En effet, un commutateur passif 6 ou 8, fonctionnant dans la bande de fréquence mentionnée ci-avant, est susceptible de perdre, en insertion, un à deux dB, selon l'isolement qui lui est demandé.

De même, une cellule de déphasage ou de retard peut présenter des pertes allant jusqu'à 2 dB pour les bits de poids moyen et fort. Ainsi, la réalisation sur technologie (MMIC) d'une ligne à longueur programmable de 9 bits comprenant 9 cellules de même structure mises en série, peut conduire à des pertes d'insertion comprises entre 30 et 40 dB.

La demanderesse s'est posée le problème de réaliser un commutateur actif en technologie MMIC, en utilisant une structure amplificatrice distribuée, en vue de réduire les pertes d'insertion.

En référence à la figure 2, la fonction réalisée par un commutateur actif peut être définie comme étant équivalente à celle réalisée par la combinaison d'un étage d'amplification EAP et d'un étage de commutation ECO.

En référence à la figure 3, un simple amplificateur distribué, conforme à l'art antérieur, comprend n cellules amplificatrices CE à base de transistors.

Pour simplifier la description, seuls les modes de réalisation à base de transistors à effet de champs montés en source commune sont ici décrits, mais l'invention s'applique aussi à d'autres types de transistors, par exemple bipolaires à hétérojonction ou analogues.

Les cellules amplificatrices sont montées entre une ligne de grille commune Lgc à laquelle sont connectées toutes les grilles des transistors des cellules amplificatrices et une ligne de drain commune Ldc où convergent les drains des transistors des cellules amplificatrices CE.

Chaque cellule amplificatrice comporte une structure amplificatrice A représentée sous la forme d'un triangle et constituée chacune d'un ou plusieurs transistors T montés en source commune. La grille du transistor est reliée à un point de la ligne de grille commune Lgc qui s'étend entre un point d'entrée du montage E et une résistance Rg reliée à la masse. Le drain du transistor est relié à un point de la ligne de drains commune Ldc qui s'étend entre une résistance Rd reliée à la masse et un point de sortie S du montage.

Les points de liaison des transistors sur la ligne de drains commune se succèdent sur ladite ligne de drains commune Ldc, dans le même ordre que les points de liaison desdits transistors, sur la ligne de grilles commune Lgc.

Chaque cellule amplificatrice est complétée par des éléments passifs servant à constituer des équivalents de tronçons de ligne de drains Ld et de la ligne de grilles Lg. Par exemple, la cellule CE2 comprend deux tronçons Lg/2 et deux tronçons Ld/2.

La tête de la ligne de grilles commune Lgc forme l'entrée E de l'amplificateur distribué. L'autre extrémité de la ligne de grilles commune Lgc est chargée sur une résistance terminale Rg qui est sensiblement égale à l'impédance caractéristique Zg de la ligne de grilles commune Lgc. Le plus souvent, la résistance terminale Rg est de 50 ohms.

De même, l'une des extrémités de la ligne de drains commune Ldc est chargée sur une résistance terminale Rd sensiblement égale à l'impédance caractéristique Zd de la ligne de drains commune Ldc, tandis que l'autre extrémité de la ligne de drains commune définit la sortie S de l'amplificateur distribué.

Des moyens de polarisation POLg appliquent une tension de polarisation continue Vg à la ligne de grilles commune Lgc à travers la résistance Rg.

De même, des moyens de polarisation POLd appliquent une tension de polarisation continue Vd à la ligne de drains commune Ldc.

Les moyens de polarisation POLd ou POLg peuvent être de différents types, notamment une inductance de forte valeur ou bien des charges saturables distribuées ou non.

Des capacités de liaisons CL1 et CL2 sont prévues respectivement entre l'entrée E et la tête de la ligne de grilles commune Lgc, et entre l'extrémité de la ligne de drains commune Ldc et la sortie S de l'amplificateur distribué.

Le fonctionnement d'un amplificateur distribué du type de celui illustré sur la figure 3 est le suivant.

Le signal d'entrée appliqué en entrée E se propage sur la ligne de grilles commune Lgc pour être absorbé par la charge Rg. Sur chaque grille de transistors passe donc une onde de tension, se propageant de la gauche vers la droite, sur la figure 3. Un courant est alors généré par chaque transistor. Il alimente la ligne de drains commune Ldc. Ce courant se propage pour partie vers la charge Rd et pour partie vers la sortie S. Les composantes qui vont vers la sortie S se superposent avec la même phase, pourvu que le temps de propagation intercellule soit identique sur la ligne de drains commune et sur la ligne de grilles commune. L'amplification est à très large bande passante, car elle commence depuis le continu jusqu'aux fréquences de coupure des filtres LC réalisées par les lignes de grilles et de drains avec les capacités parasites des transistors. Ces fréquences de coupure peuvent être très hautes, de plusieurs dizaines de GHz, à la centaine de GHz, avec des conceptions appropriées.

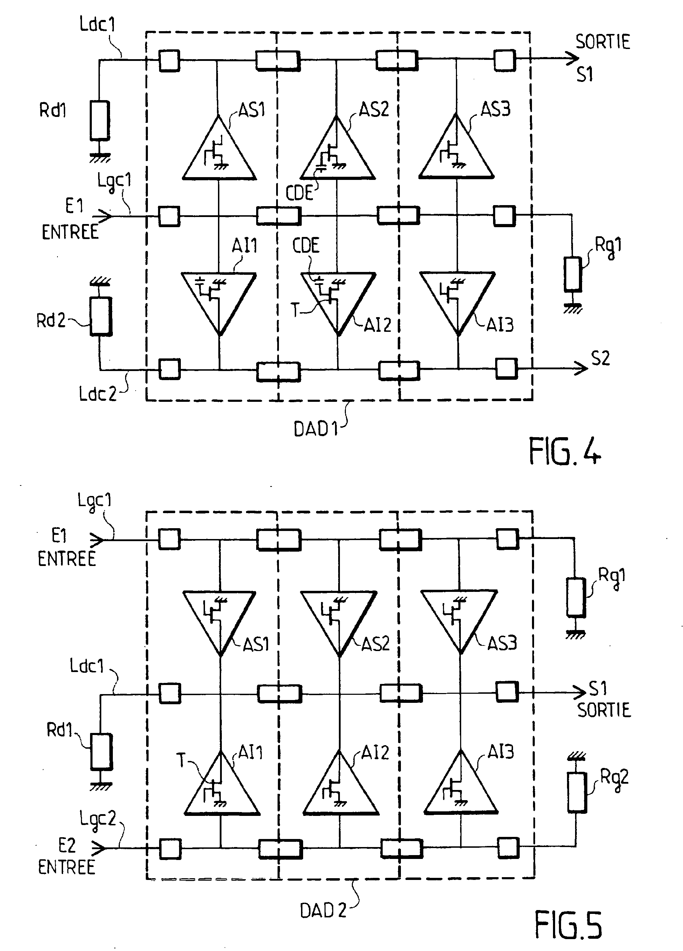

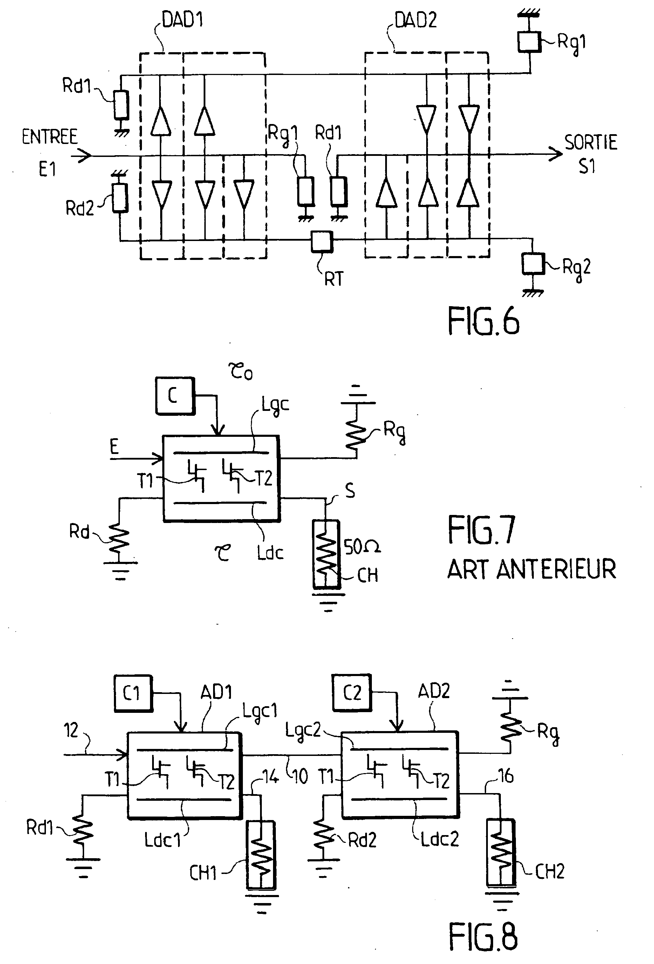

En référence aux figures 4 et 5, la demanderesse a observé qu'un commutateur actif est susceptible d'être réalisé, sur le principe d'un double amplificateur distribué.

En pratique, un double amplificateur distribué comprend une ligne de grilles commune Lgc1 et deux lignes de drains communes Ldc1 et Ldc2 pour réaliser un commutateur actif à une entrée et deux sorties (DAD1, figure 4) ou comprend deux lignes de grilles communes Lgc1 et Lgc2 et une ligne de drains commune Ldc1 pour réaliser un commutateur actif à deux entrées et une sortie (DAD2, figure 5).

En référence à la figure 4, la ligne centrale est la ligne de grilles commune Lgc1. Les lignes inférieures et supérieures sont les lignes de drains communes Ldc1 et Ldc2.

Des moyens de polarisation (non représentés) sont prévus pour polariser (commander) les transistors T des structures amplificatrices supérieures AS (individualisées en AS1 à AS3) et inférieures AI (individualisées en AI1 à AI3), soit en mode amplificateur, soit en mode bloqué.

Par exemple, les moyens de polarisation sont similaires à ceux décrits en référence à la figure 3.

En pratique, la commande de commutation entre le mode bloqué et le mode amplificateur, est appliquée sur les grilles des transistors T des structures amplificatrices supérieures AS et inférieures AI. On peut aussi appliquer la commande de commutation sur les drains mais cette solution est plus complexe en raison du courant de drain qui pénalise la rapidité de la commande.

Une capacité CDE peut être reliée en série avec la capacité de la grille (CGS) d'un transistor T pour former un pont capacitif. Un tel pont diminue le gain en fonction de la fréquence. Ainsi, le gain de chaque cellule peut être modulé en amplitude absolue ou en amplitude en fonction de la fréquence selon la présence et la valeur de la capacité CDE entre la ligne de grille commune et la grille d'un transistor. Cette modulation peut s'appliquer à l'amplitude sur toute la bande de fréquences ou bien à une variation de l'amplitude en fonction de la fréquence pour la création d'une pente positive en vue de compenser les pertes des circuits passifs.

Les moyens de polarisation sont agencés de sorte que lorsque les transistors T des structures amplificatrices supérieures AS sont polarisés dans un état bloqué, les transistors T des structures amplificatrices inférieures AI sont polarisés dans un état amplificateur, et réciproquement.

Le fonctionnement d'un double amplificateur distribué DAD1 du type dans lequel les transistors T des structures amplificatrices supérieures AS sont polarisés dans un état bloqué tandis que les transistors T des structures amplificatrices inférieures AI sont polarisés dans un état amplificateur, est le suivant.

Le signal d'entrée appliqué en entrée E1 se propage sur la ligne de grilles commune Lgc1 pour être absorbé par la charge Rgl. Sur chaque grille de transistors de chaque structure amplificatrice inférieure passe donc une onde de tension, se propageant de la gauche vers la droite, sur la figure 4. Un courant est alors généré par chaque transistor de chaque structure amplificatrice inférieure. Ce courant ainsi généré alimente la ligne de drains commune Ldc2. Ce courant se propage pour partie vers la charge Rd2 et pour partie vers la sortie S2. Les composantes qui vont vers la sortie S2 se superposent avec la même phase, pourvu que le temps de propagation intercellule soit identique sur la ligne de drains commune Ldc2 et sur la ligne de grilles Lgc1. L'amplification est alors la somme des amplifications réalisées par chaque transistor de chaque structure amplificatrice inférieure. Aucun courant ne se propage sur la ligne de drains commune Ldc1 dans la mesure où les transistors des structures amplificatrices supérieures sont polarisés en mode bloqué.

De même, en commutant la polarisation des structures amplificatrices inférieures et supérieures respectivement en mode bloqué et en mode amplificateur, on obtient un courant qui se propage vers la sortie S1 et aucun courant vers la sortie S2.

Un tel double amplificateur distribué DAD1 peut être réalisé à l'aide de transistors appartenant à la filière PH25 de la Fonderie UMS (société Franco-Allemande).

Par exemple, dans le cas du double amplificateur distribué décrit en référence à la figure 4, le gain obtenu dans la bande de fréquence 1 à 20 GHz, est de l'ordre de +7 dB pour la voie amplifiée, et de l'ordre de - 20 dB pour la voie bloquée.

Le comportement du circuit décrit en référence à la figure 4 en régime grand signal montre une puissance de sortie supérieure à 10 dBm avec 1 dB de compression pour une consommation de 38 mA sur 3 volts, ce qui correspond à une puissance consommée inférieure à 120 mW.

Le gain, la puissance de sortie et la consommation peuvent être ajustés en faisant varier le nombre de cellules, la taille des transistors T, ainsi que le nombre de capacités CDE.

En référence à la figure 5, la ligne centrale est la ligne de drains commune Ldgcl. Les lignes inférieures et supérieures sont les lignes de grilles communes Lgc1 et Lgc2.

Comme dans le double amplificateur distribué de la figure 4, le double amplificateur de la figure 5 comprend des moyens de polarisation (non représentés) pour commander les transistors T des structures amplificatrices supérieures AS et inférieures AI, soit en mode amplificateur, soit en mode bloqué, en fonction de la valeur du bit d'entrée de la commande numérique.

Les moyens de polarisation sont agencés de sorte que lorsque les transistors T des structures amplificatrices supérieures AS sont polarisés dans un état bloqué, les transistors T des structures amplificatrices inférieures AI sont polarisés dans un état amplificateur, et réciproquement.

Le fonctionnement d'un double amplificateur distribué DAD2 du type dans lequel les transistors T des structures amplificatrices supérieures AS sont polarisés dans un état bloqué tandis que les transistors T des structures amplificatrices inférieures AI sont polarisés dans un état amplificateur, est le suivant.

Le signal d'entrée appliqué en entrée E2 se propage sur la ligne de grilles commune Lgc2 pour être absorbé par la charge Rg2. Sur chaque grille de transistors de chaque structure amplificatrice inférieure passe donc une onde de tension, se propageant de la gauche vers la droite, sur la figure 5. Un courant est alors généré par chaque transistor de chaque structure amplificatrice inférieure. Ce courant ainsi généré alimente la ligne de drains commune Ldc1. Ce courant se propage pour partie vers la charge Rd1 et pour partie vers la sortie S1. Les composantes qui vont vers la sortie S1 se superposent avec la même phase, pourvu que le temps de propagation intercellule soit identique sur la ligne de drains commune Ldc1 et sur la ligne de grilles commune Lgc2. L'amplification est alors la somme des amplifications réalisées par chaque transistor de chaque structure amplificatrice inférieure. Seul le signal se propageant sur la ligne de grille commune Lgc2 est amplifié dans la mesure où les transistors des structures amplificatrices supérieures sont polarisés en mode bloqué.

De même, en commutant la polarisation des structures amplificatrices inférieures et supérieures respectivement en mode bloqué et en mode amplificateur, on obtient une amplification du signal qui se propage sur la ligne de grilles commune Lgc1 et une atténuation très forte du signal présent sur la ligne de grilles commune Lgc2.

En référence à la figure 6, on a représenté un double amplificateur distribué DAD1, sensiblement similaire à celui décrit en référence à la figure 4, mis en série avec un double amplificateur distribué DAD2, sensiblement similaire à celui décrit en référence à la figure 5.

Une telle structure permet de réaliser un dispositif de contrôle de phase tel que décrit en référence à la figure 1, dans lequel le double amplificateur distribué DAD1 joue le rôle de commutateur actif amont, et dans lequel le double amplificateur distribué DAD2 joue le rôle de commutateur actif aval.

Le double amplificateur distribué DAD1 de la figure 6 comprend par exemple une structure amplificatrice supérieure en moins (la dernière en partant de la gauche) par rapport au double amplificateur distribué DAD1 de la figure 4. Une telle suppression modifie le temps de propagation du courant sur la ligne de drains Ldc1.

De même, le double amplificateur distribué DAD2 de la figure 6 comprend par exemple une structure amplificatrice supérieure en moins (la première en partant de la gauche) par rapport au double amplificateur distribué DAD2 de la figure 5.

Un retard temporel passif RT peut être ajouté entre la ligne de drains Ldc2 du double amplificateur distribué DAD1 et la ligne de grilles Lgc2 du double amplificateur distribué DAD2.

La ligne supérieure constitue une première voie tandis que la ligne inférieure constitue une seconde voie.

Le choix de la commande des transistors permet de faire passer le courant soit selon la première voie, soit selon la seconde voie.

Le choix de la voie peut être déterminé en fonction du retard temporel à appliquer audit courant, ledit retard étant fonction du nombre de structures amplificatrices et de la valeur du retard RT.

Il convient de remarquer que les structures amplificatrices représentées sous la forme d'un triangle en référence aux figures 3 à 6 peuvent comprendre un ou plusieurs transistors, de type à effet de champ ou bipolaire, avec ou sans montage cascode, avec ou sans capacité CDE en série avec la capacité de la grille du transistor.

En référence à la figure 7, on a représenté un simple amplificateur distribué AD, conforme à la technique antérieure, selon une variante de représentation schématique légèrement différente de celle utilisée en figure 3 et qui sera reprise dans les figures suivantes.

La référence C désigne les moyens de commande numérique qui agissent sur l'état bloqué ou amplificateur des transistors T de l'amplificateur distribué AD.

L'entrée E de l'amplificateur distribué AD est reliée à l'une des extrémités de la ligne de grilles commune Lgc.

La référence CH désigne la charge sur laquelle est reliée la sortie S de l'amplificateur distribué AD. Classiquement, la charge a une valeur de 50 ohms et les impédances caractéristiques Zd et Zg respectivement des lignes de drains communes Ldc et de grilles communes Lgc sont de 50 ohms. Les résistances terminales Rg et Rd sont de 50 ohms.

Il est clair que le nombre de cellules (ici 2) et le nombre de transistors par cellule (ici 1) ne sont donnés qu'à titre illustratif, il peuvent être bien évidemment différents de ceux représentés en référence à la figure 7.

τ0 est le temps de propagation du courant le long de la ligne de grilles commune Lgc1, de l'entrée E jusqu'au point Rg.

τ est le temps de propagation du courant de l'entrée E jusqu'à la sortie S.

τ - τ0 représente approximativement le temps de retard au passage de l'élément actif (transistor) de chacune des cellules (supposées identiques). Pour simplifier, on pourra considérer que cette différence est nulle puisque l'on s'intéressera ci-après seulement aux retards relatifs.

Par ailleurs, on supposera par la suite que les différentes lignes de drains et de grilles sont peu dispersives, c'est-à-dire que les temps mentionnés ci-dessus sont sensiblement constants dans la bande de fréquence visée.

En référence à la figure 8, la demanderesse a observé de façon surprenante que des circuits de commutation distribués sont susceptibles d'être réalisés à l'aide d'un double amplificateur distribué LAD constitué de deux amplificateurs distribués AD1 et AD2, similaires à ceux décrits en référence à la figure 7, et mis en série au niveau de leurs lignes de grilles selon l'invention.

Plus précisément, le double amplificateur distribué LAD comprend une ligne de grilles commune 10 formée de deux tronçons de ligne de grilles Lgc1 et Lgc2 mis en série et deux lignes de drains séparées Ldc1 et Ldc2 pour réaliser deux circuits de commutation distribués à une entrée 12 et deux sorties 14 et 16.

Le tronçon de ligne de grilles Lgc1 est la ligne de grilles commune de l'amplificateur distribué AD1 dont la structure est similaire à celle du simple amplificateur distribué AD décrit en référence à la figure 7, tandis que le tronçon de ligne de grilles Lgc2 est la ligne de grilles commune de l'amplificateur distribué AD2 dont la structure est similaire à celle du simple amplificateur distribué AD décrit en référence à la figure 7.

L'entrée 12 du double amplificateur distribué LAD est reliée à l'une des extrémités de la ligne de grilles Lgc1. L'autre extrémité de la ligne de grilles Lgc1 est reliée directement (ou via un retard passif) à l'une des extrémités de la ligne de grilles Lgc2. L'autre extrémité de la ligne de grilles Lgc2 est reliée à la résistance terminale Rg.

L'une des extrémités de la ligne de drains Ldc1 est reliée à la résistance terminale Rd1. L'autre extrémité de la ligne de drains Ldc1 est reliée à une charge CH1, via la sortie 14. De même, l'une des extrémités de la ligne de drains Ldc2 est reliée à la résistance terminale Rd2. L'autre extrémité de la ligne de drains Ldc2 est reliée à une charge CH2, via la sortie 16.

Les impédances des charges CH1 et CH2 sont classiquement de 50 ohms.

La commande des moyens de polarisations continues C1 des grilles et des drains des transistors T de l'amplificateur distribué AD1 et les moyens de polarisations continues C2 des grilles et des drains des transistors T de l'amplificateur distribué AD2 est choisie de sorte que les transistors T de l'amplificateur AD1 sont polarisés en mode passant (ou amplificateur) lorsque les transistors T de l'amplificateur AD2 sont polarisés en mode bloqué et réciproquement.

En configurant la commande des transistors des amplificateurs distribués AD1 et AD2 respectivement en mode bloqué et en mode amplificateur, on obtient un courant qui se propage jusqu'à la sortie 14 et aucun courant jusqu'à la sortie 16.

Réciproquement, en configurant la commande des transistors des amplificateurs distribués AD1 et AD2 respectivement en mode amplificateur et en mode bloqué, on obtient un courant qui se propage jusqu'à la sortie 16 et aucun courant jusqu'à la sortie 14.

Comme le double amplificateur de la figure 4, le double amplificateur de la figure 8 est adapté à la commutation active. De plus, comme on le verra plus en détail ci-après, sa structure peut aussi servir à la réalisation d'une ligne à longueur programmable (ligne à retard).

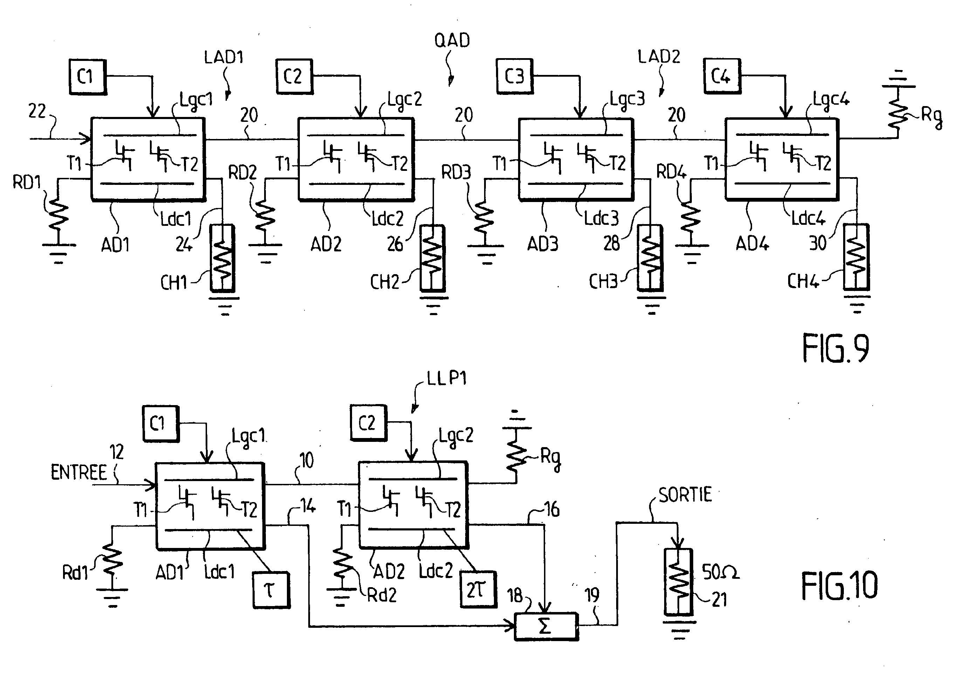

En référence à la figure 9, on a représenté un quadruple amplificateur distribué QAD constitué de deux doubles amplificateurs distribués LAD1 et LAD2, similaires à ceux décrits en référence à la figure 8, et mis en série selon l'invention.

Selon l'invention, le quadruple amplificateur distribué QAD comprend une ligne de grilles commune 20 formée de quatre tronçons de lignes de grilles Lgc1 à Lgc4 mis en série et quatre lignes de drains séparées Ldc1 à Ldc4 pour réaliser l'équivalent de quatre circuits de commutation distribuées à une entrée 22 et quatre sorties 24, 26, 28, et 30.

Le gain du double ou du quadruple amplificateur est de l'ordre de +7 à +10 dB dans la gamme de fréquence 1-20 GHz.

En référence à la figure 10, la demanderesse a observé de façon surprenante qu'une ligne à longueur programmable LLP1 de 1 bit est susceptible d'être réalisée à l'aide d'un double amplificateur distribué constitué de deux amplificateurs distribués AD1 et AD2, similaires à ceux décrits en référence à la figure 7, mis en série conformément à la figure 8, et dont les sorties 14 et 16 sont reliées à un organe sommateur 18, la sortie 19 de l'organe sommateur 18 étant reliée à une charge unique 21, classiquement de 50 ohms.

τ est le temps de propagation du courant de l'entrée 12 jusqu'à la sortie 14.

2τ est le temps de propagation du courant de l'entrée 12, jusqu'à la sortie 16.

En configurant la commande des transistors des amplificateurs distribués AD1 et AD2 respectivement en mode amplificateur et en mode bloqué, on obtient un courant qui se propage selon un temps de propagation égal à τ jusqu'à la sortie 19, via la sortie 14.

En configurant la commande des transistors des amplificateurs distribués AD1 et AD2 respectivement en mode bloqué et en mode amplificateur, on obtient un courant qui se propage selon un temps de propagation égal à 2τ jusqu'à la sortie 19, via la sortie 16.

Ainsi, selon la valeur de la commande, le signal est amplifié par l'étage AD1 et retardé de τ ou bien amplifié par l'étage AD2 et retardé de 2 r. La différence de retard est égale à τ entre les deux états.

Il est à observer qu'il y a une différence de niveau due aux pertes dans les lignes de grilles et au fait que lesdites lignes sont mises en série.

Selon l'invention, cette différence de niveau peut être compensée en ajoutant une dissymétrie entre les deux étages AD1 et AD2. Par exemple, l'étage AD2 peut avoir un gain plus important que l'étage AD1, le cas échéant avec une pente légèrement positive en fonction de la fréquence. Cette compensation peut aussi être obtenue en jouant sur la taille des transistors et sur les circuits passifs constituant les lignes de grilles et de drains. La capacité CDE mentionnée ci-avant et mise en série avec la capacité de la grille de transistor permet aussi d'obtenir une pente de gain positive en fréquence.

Il y a lieu de remarquer selon l'invention que le circuit LLP1 décrit en référence à la figure 10 réalise simultanément les quatre fonctions suivantes : amplification, commutation, retard, et correction de gain.

De plus, le niveau "haut" de tension de grille associé à la valeur 1 de la commande de polarisation C peut varier, par exemple en fonction de la température pour réaliser une correction de gain intervenant dans l'ensemble du circuit. Avec une telle compensation, chaque structure distribuée réalise ainsi les fonctions suivantes : amplification, commutation, retard, correction de gain, et compensation de gain.

Pour considérer le circuit de la figure 10 comme une ligne à longueur programmable active, il convient de combiner les deux sorties 14 et 16 en une sortie 19. C'est le rôle d'un organe sommateur 18 qui peut être extérieur ou non au circuit. Un pont de type wilkinson peut être utilisé comme organe sommateur passif. L'organe sommateur peut aussi être de type actif comme l'organe sommateur (deux entrées et une sortie) décrit en référence à la figure 5.

Selon le principe décrit en référence à la figure 10, et en agissant sur la topologie des organes sommateurs, il est possible selon l'invention de réaliser une multitude de circuits répondant à la définition d'une ligne à longueur programmable active à n bits. En effet, les simples structures distribuées AD peuvent constituer des chaînes à retard à plusieurs maillons constitués chacun de simples structures distribuées toutes mises en série au niveau de leurs lignes de grilles.

De plus, il convient de noter que les structures amplificatrices distribuées offrent certains choix dans l'impédance des lignes des drains qui sont appliquées aux organes sommateurs. On peut donc optimiser le choix de l'organe sommateur (actif ou passif) ainsi que l'impédance des lignes de drains (50, 100, ou 200 ohms).

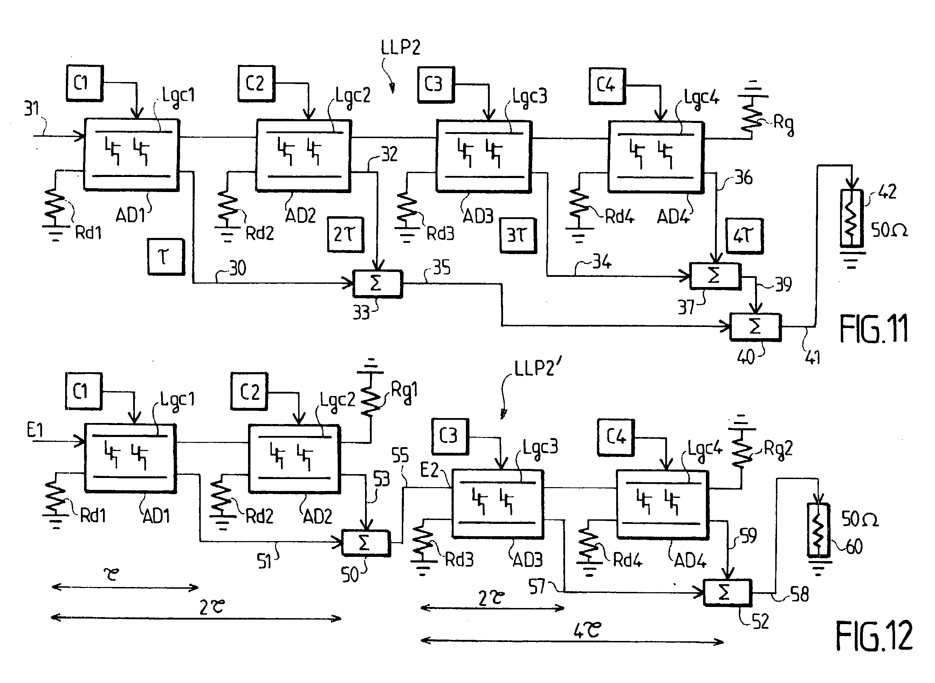

En référence à la figure 11, on a représenté une ligne à longueur programmable LLP2 à 2 bits, réalisée à l'aide d'un quadruple amplificateur distribué constitué de deux doubles amplificateurs distribués LLP1, similaires à ceux décrits en référence à la figure 10, mis en série conformément à la figure 10, et dont les sorties 30 et 32 sont reliées à un premier organe sommateur 33 et dont les sorties 34 et 36 sont reliées à un second organe sommateur 37, la sortie 35 du premier organe sommateur 33, ainsi que la sortie 39 du second organe sommateur étant reliées à un troisième organe sommateur 40 dont la sortie 41 est reliée à la charge unique 42, classiquement d'impédance 50 ohms.

τ est le temps de propagation du courant de l'entrée 31 jusqu'à la sortie 30.

2τ est le temps de propagation du courant de l'entrée 31 jusqu'à la sortie 32.

3τ est le temps de propagation du courant de l'entrée 31 jusqu'à la sortie 34.

4τ est le temps de propagation du courant de l'entrée 31 jusqu'à la sortie 36.

Par exemple, en configurant la commande des transistors des amplificateurs distribués AD1 en mode amplificateur et la commande des transistors des amplificateurs distribués AD2 à AD4 en mode bloqué, on obtient un courant qui se propage selon un temps de propagation égal à τ jusqu'à la sortie 41, via l'organe sommateur 33.

Par exemple, en configurant la commande des transistors des amplificateurs distribués AD1 à AD3 en mode bloqué et la commande des transistors des amplificateurs distribués AD4 en mode amplificateur, on obtient un courant qui se propage selon un temps de propagation égal à 4τ jusqu'à la sortie 41, via l'organe sommateur 37.

La ligne LLP2 de la figure 11 correspond à une chaîne à retard à 4 maillons de 1τ de retard chacun.

En référence à la figure 12, on a représenté une variante de réalisation d'une ligne à longueur programmable LLP2' à 2 bits selon l'invention.

Dans cette variante, la ligne à longueur programmable à 2 bits LLP2' comprend deux organes sommateurs 50 et 52 au lieu de trois comme dans celle décrite en référence à la figure 10.

Elle comprend 4 cellules à structures distribuées simples AD1 à AD6. Les deux premières cellules AD1 à AD2 sont mises en série conformément au double amplificateur de la figure 10. Les sorties des deux premières 51, et 53 sont reliées à un organe sommateur 50 dont la sortie 55 est reliée à l'entrée de la troisième cellule AD3. Les troisième et quatrième cellules AD3 et AD4 sont mises en série conformément au double amplificateur de la figure 10. Les sorties des troisième et quatrième cellules 57 et 59 sont reliées à un organe sommateur 52 dont la sortie 58 est reliée à la charge 60 d'impédance 50 ohms.

Selon la configuration de la commande, le signal peut être retardé de 3τ, 4τ, 5τ ou 6τ, soit 4 états, c'est-à-dire 2 bits.

Ainsi, la ligne LLP2' de la figure 12 correspond à deux chaînes à retard mises en série, la première chaîne à retard ayant 2 maillons de 1τ de retard chacun et la seconde chaîne à retard ayant 2 maillons de 2τ de retard chacun.

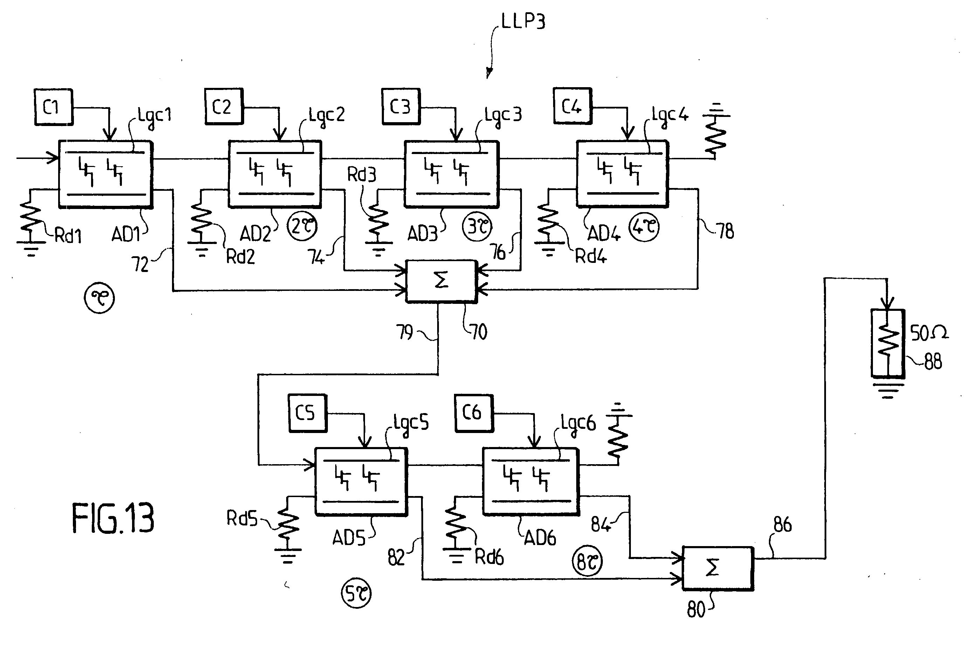

En référence à la figure 13, on a représenté une ligne à longueur programmable LLP3 à 3 bits.

Elle comprend 6 cellules à structures distribuées simples AD1 à AD6. Les quatre premières cellules AD1 à AD4 sont mises en série conformément au quadruple amplificateur de la figure 11. Les sorties des quatre premières 72, 74, 76, et 80 sont reliées à un organe sommateur 70 dont l'unique sortie 79 est reliée à l'entrée de la cinquième cellule AD5. Les cinquième et sixième cellules AD5 et AD6 sont mises en série conformément au double amplificateur de la figure 10. Les sorties des cinquième et sixième cellules 82 et 84 sont reliées à un organe sommateur 80 dont la sortie 86 est reliée à la charge 88 d'impédance 50 ohms.

Selon la configuration de la commande, le signal peut être retardé de 5τ, 6τ, 7τ, 8τ, 9τ, 10τ, 11τ, ou 12τ, soit 8 états, c'est-à-dire 3 bits.

Ainsi, la ligne LLP3 de la figure 13 correspond à deux chaînes à retard mises en série, la première chaîne à retard ayant 4 maillons de 1τ de retard chacun et la seconde chaîne ayant 2 maillons de 4τ de retard chacun.

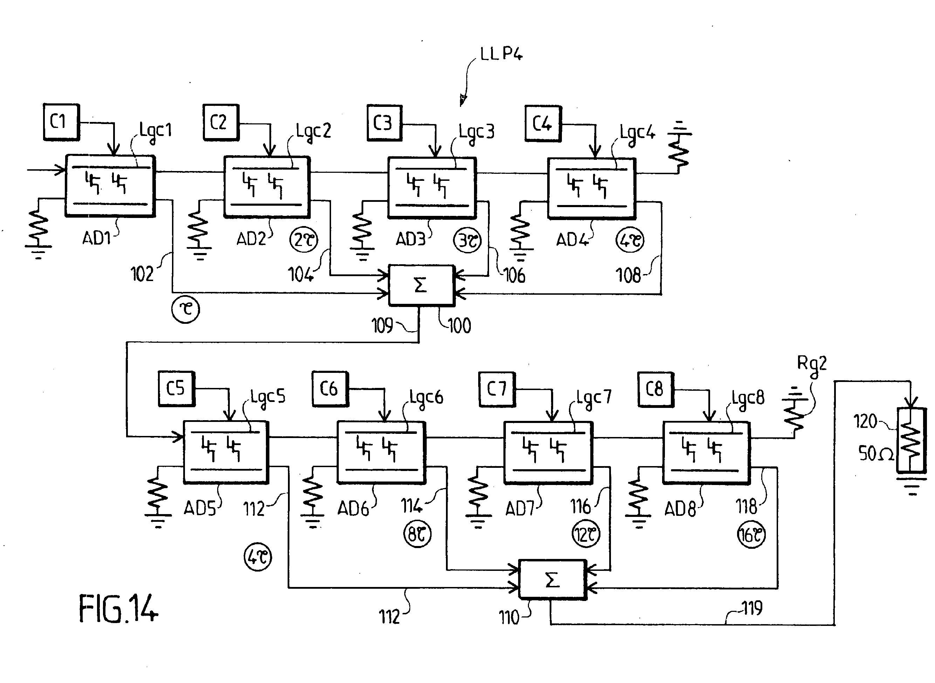

En référence à la figure 14, on a représenté une ligne à longueur programmable LLP4 à 4 bits.

La ligne LLP4 comprend 8 cellules à structures distribuées simples AD1 à AD8. Les quatre premières cellules AD1 à AD4 sont mises en série conformément au quadruple amplificateur de la figure 11. Les sorties des quatre premières cellules 102, 104, 106, et 108 sont reliées à un organe sommateur 100 dont la sortie 109 est reliée à l'entrée de la cinquième cellule AD5. Les quatre dernières cellules AD5 à AD8 sont mises en série conformément au quadruple amplificateur de la figure 11. Les sorties des quatre dernières cellules premières 112, 114, 116, et 118 sont reliées à un organe sommateur 110 dont la sortie 119 est reliée à la charge 120, d'impédance 50 ohms.

Selon la configuration de la commande, le signal peut être retardé de 5τ, 6τ, 7τ, 8τ, 9τ, 10τ, 11τ, 12τ, 13τ, 14τ, 15τ, 16τ, 17τ, 18τ, 19τ, ou 20τ, soit 16 états, c'est-à-dire 4 bits.

Ainsi, la ligne LLP4 de la figure 14 correspond à deux chaînes à retard mises en série, la première chaîne à retard ayant 4 maillons de 1τ de retard chacun et la seconde chaîne ayant 4 maillons de 4τ de retard chacun.

Dans les figures 10 à 14, les maillons d'une même chaîne à retard sont tous identiques et comprennent un retard individuel de même valeur pour des raisons d'équilibrage d'amplitude.

Dans les figures 10 à 14, les organes sommateurs engendrent des pertes ou des limitations de bande lorsqu'ils sont passifs, ou une consommation importante lorsqu'ils sont actifs.

La demanderesse s'est posée le problème de résoudre ces problèmes.

La présente invention apporte justement une solution à base d'un double amplificateur distribué à configuration dite "auto-recombineuse" dans laquelle la ligne de drain joue le rôle de sommateur.

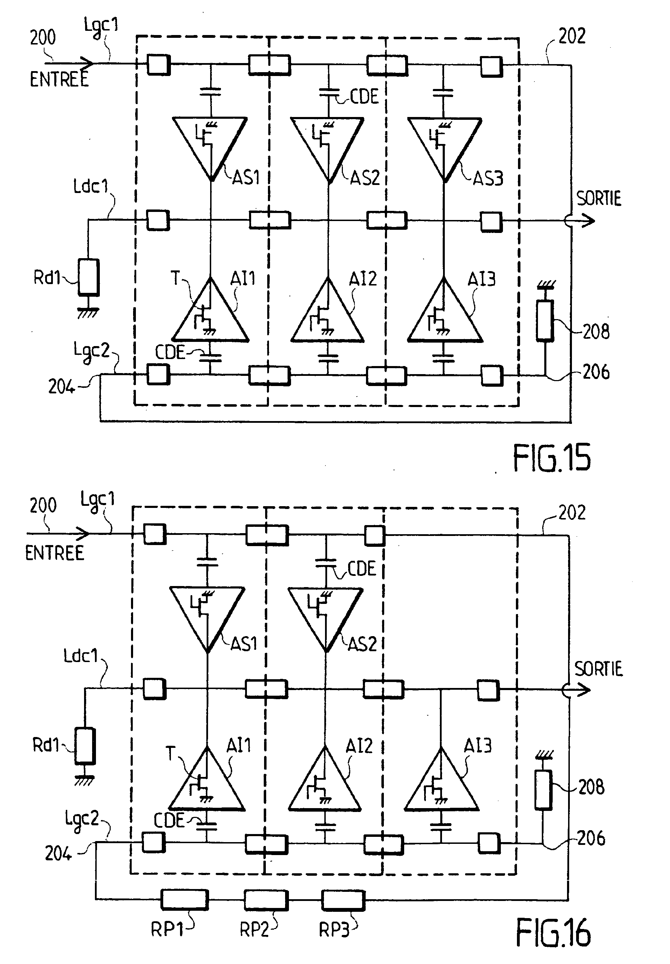

Plus précisément, en référence à la figure 15, on a représenté un tel double amplificateur "auto-recombineur" selon l'invention dans lequel l'extrémité 202 de la ligne de grilles commune Lgc1, opposée à l'entrée 200, est reliée directement à l'extrémité 204 de la ligne de grilles commune Lgc2, opposée à l'extrémité 206 reliée à la résistance terminale 208.

Une telle connexion entre la fin d'une ligne de grilles commune Lgc1 et le début d'une autre ligne de grilles commune Lgc2 permet de réaliser la structure dite "auto-recombineuse".

La ligne de drains unique Ldc1 sert ici d'organe sommateur. Elle recueille les signaux amplifiés soit de la ligne de grilles supérieure Lgc1, avec un certain temps de retard, soit de la ligne de grilles inférieure Lgc2, soit avec un temps de retard sensiblement le double de celui de la ligne supérieure.

En référence à la figure 16, le rebouclage d'une ligne de grille sur l'autre peut lui-même comporter un retard; qui peut être réalisé sur le circuit (puce) ou bien à l'extérieur. Un tel retard permet d'augmenter la différence de retard entre les deux états et réaliser un bit de ligne de longueur programmable de plus fort poids.

Par exemple, le rebouclage entre la fin de la ligne Lgc1 et le début de la ligne Lgc2 comprend 3 retards passifs RP1 à RP3, de valeur individuelle τ pour simplifier.

La ligne de grilles inférieure Lgc2 comprend une cellule active supplémentaire par rapport à la ligne de grilles supérieure Lgc1, pour compenser les pertes dues aux cellules passives RP1 à RP3 insérées entre les lignes Lgc1 et Lgc2. Cette cellule active supplémentaire représente une cellule passive sur la ligne de drains lorsque les transistors supérieurs sont en mode amplificateur.

Si, pour simplifier, on suppose que toutes les cellules passives ou actives retardent le signal d'un même temps τ, les deux états sont caractérisés par un retard de 3r lorsque les transistors supérieurs sont en mode amplificateurs, ou par un retard de 8r lorsque les transistors inférieurs sont en mode amplificateur. Le retard relatif en figure 16 est donc de 5 τ au lieu d'être d'r en figure 15.

Les solutions décrites selon l'invention en référence aux figures 4 à 16, présentent toutes certains avantages en terme de réduction de pertes d'insertion. De plus, l'intérêt de l'utilisation de la technologie MMIC est dans la possibilité de combiner à volonté les différentes solutions mentionnées ci-avant. Par exemple, on peut réaliser des commutateurs actifs à 4 voies. On peut aussi associer des étages à base 4 avec d'autres à base 2 ou combiner des retards et des déphasages. On peut également moduler le gain des commutateurs et choisir leur emplacement en fonction des contraintes de dynamique et de facteur de bruit.

## Revendications

1. Double amplificateur distribué, comprenant au moins une première ligne (Lgc1, Ldc1, 10) dont une extrémité forme borne commune pour des moyens de commutation (T), au moins des deuxième (Ldc1, Lgc1, Ldc1) et troisième lignes (Ldc2, Lgc2, Ldc2) dont les extrémités forment les bornes commutées pour les moyens de commutation (T), et, entre la première ligne et chacune des deux lignes commutées au moins un élément actif commutable (T), l'élément actif commutable disposé entre la première ligne (Lgc1, Ldc1, 10) et la deuxième ligne (Ldc1, Lgc1, Ldc1) étant polarisé en mode amplificateur lorsque l'élément actif commutable disposé entre la première ligne (Lgc1, Ldc1, 10) et la troisième ligne (Ldc2, Lgc2, Ldc2) est polarisé bloquant et réciproquement, ledit double amplificateur distribué assurant ainsi la fonction de commutation active, **caractérisé en ce que** l'une des extrémités de la deuxième ligne (Ldc1, Ldg1, Ldc1) et l'une des extrémités de la troisième ligne (Ldc2, Ldg2, Ldc2) sont reliées l'une et l'autre à un organe sommateur, le double amplificateur distribué formant une ligne à longueur programmable à 1 bit.

2. Dispositif de contrôle de phase à commande numérique, comprenant une entrée de commande numérique, et, entre une entrée de signal (2) et une sortie de signal (4), au moins un circuit comportant des moyens de commutation aptes, sous contrôle d'un bit de l'entrée de commande, à procurer au moins deux fonctions de transfert différentes en termes de phase et/ou retard temporel, **caractérisé en ce que** le circuit comprend au moins un double amplificateur distribué (DAD1, DAD2, LAD) selon la revendication 1.

3. Dispositif selon la revendication 2, **caractérisé en ce que** l'organe sommateur (18) est actif.

4. Dispositif selon la revendication 2, **caractérisé en ce que** l'organe sommateur (18) est passif.

5. Dispositif selon la revendication 2, **caractérisé en ce que** l'organe sommateur est formé par la mise en série des deuxième et troisième lignes (Lgc1, Lgc2) du double amplificateur distribué, le double amplificateur distribué formant ainsi une structure auto-recombineuse.

6. Dispositif selon l'une des revendications 2 à 4, **caractérisé en ce que** le double amplificateur distribué (LAD) comprend au moins des première et seconde simples structures distribuées (AD1,AD2) comprenant chacune une ligne de grilles commune (Lgc1) et une ligne de drains commune (Ldc1), l'une des extrémités de la ligne de grilles commune de la première structure (AD1) étant reliée à l'une des extrémités de la ligne de grilles commune de la seconde structure (AD2) pour former la première ligne (10) du double amplificateur distribué (LAD), tandis que les lignes de drains des première et seconde structures distribuées (AD1 et AD2) constituent respectivement les deuxième et troisième lignes du double amplificateur distribué (LAD).

7. Dispositif selon la revendication 6, **caractérisé en ce qu'**il comprend au moins deux doubles amplificateurs distribués (LAD1, LAD2), mis en série pour former un quadruple amplificateur distribué (QAD) à commutation active.

8. Dispositif selon la revendication 6, **caractérisé en ce que** l'une des extrémités de la deuxième ligne (Ldc1) et l'une des extrémités de la troisième ligne (Ldc2) sont reliées l'une et l'autre à un organe sommateur passif ou actif (18) dont la sortie est reliée à une charge (21), les première et seconde simples structures distribuées (AD1, AD2) formant une ligne à longueur programmable (LLP1) à 1 bit.

9. Dispositif selon la revendication 8, **caractérisé en ce qu'**il comprend plusieurs simples structures distribuées (AD1, AD2, AD3,...) dont les lignes de grilles communes sont mises en série directement ou indirectement pour former des lignes à longueur programmable (LLP2, LLP2', LLP3, LLP4) de plusieurs bits.

10. Dispositif selon la revendication 5, **caractérisé en ce que** la connexion entre l'une (202) des extrémités de la deuxième ligne (Lgc1) et l'une (204) des extrémités de la troisième ligne (Lgc2) comprend au moins un retard passif (RP1 à RP3).

11. Dispositif selon l'une des revendications 2 à 10, **caractérisé en ce que** les éléments actifs commutables comprennent des transistors (T) à effets de champs, des transistors bipolaires à hétérojonction ou analogues.

12. Dispositif selon l'une quelconque des revendications 2 à 11, **caractérisé en ce qu'**il est apte à fonctionner dans une très large bande de fréquences allant du continu jusqu'à plusieurs dizaines de GHz.

13. Dispositif selon l'une des revendications 2 à 12, **caractérisé en qu'**il est réalisé en technologie des circuits intégrés monolithiques micro-ondes.

## Claims

1. Dual distributed amplifier, comprising at least a first line (Lgc1, Ldc1, 10), one end of which forms a common terminal for switching means (T), at least second (Ldc1, Lgc1, Ldc1) and third lines (Ldc2, Lgc2, Ldc2), the ends of which form the switched terminals for the switching means (T), and, between the first line and each of the two switched lines, at least one switchable active element (T), the switchable active element disposed between the first line (Lgc1, Ldc1, 10) and the second line (Ldc1, Lgc1, Ldc1) being biased into amplifier mode when the switchable active element disposed between the first line (Lgc1, Ldc1, 10) and the third line (Ldc2, Lgc2, Ldc2) is biased into off state and vice versa, the said dual distributed amplifier thus providing the active switching function, **characterized in that** one of the ends of the second line (Ldc1, Ldg1, Ldc1) and one of the ends of the third line (Ldc2, Ldg2, Ldc2) are each connected to a summing device, the dual distributed amplifier forming a 1-bit programmable length line.

2. Phase control device with digital control, comprising a digital control input and, between a signal input (2) and a signal output (4), at least one circuit comprising switching means capable, under the control of one bit from the control input, of providing at least two different transfer functions in terms of phase and/or time delay, **characterized in that** the circuit comprises at least one dual distributed amplifier (DAD1, DAD2, LAD) according to Claim 1, the switchable active element being controlled as a function of the control bit of the cell.

3. Device according to Claim 2, **characterized in that** the summer device (18) is active.

4. Device according to Claim 2, **characterized in that** the summer device (18) is passive.

5. Device according to Claim 2, **characterized in that** the summer device (18) is formed by the serial connection of the second and third lines (Lgc1, Lgc2) of the dual distributed amplifier, the dual distributed amplifier thus forming a self-recombining structure.

6. Device according to one of Claims 2 to 4, **characterized in that** the dual distributed amplifier (LAD) comprises at least first and second simple distributed structures (AD1, AD2) each comprising a common gate line (Lgc1) and a common drain line (Ldc1), one of the ends of the common gate line of the first structure (AD1) being connected to one of the ends of the common gate line of the second structure (AD2) so as to form the first line (10) of the dual distributed amplifier (LAD), whereas the drain lines of the first and second distributed structures (AD1 and AD2) respectively form the second and third lines of the dual distributed amplifier (LAD).

7. Device according to Claim 6, **characterized in that** it comprises at least two dual distributed amplifiers (LAD1, LAD2), connected in series so as to form an actively-switched quadruple distributed amplifier (QAD).

8. Device according to Claim 6, **characterized in that** one of the ends of the second line (Ldc1) and one of the ends of the third line (Ldc2) are each connected to a passive or active summer device (18) whose output is connected to a load (21), the first and second simple distributed structures (AD1, AD2) forming a 1-bit programmable length line (LLP1).

9. Device according to Claim 8, **characterized in that** it comprises several simple distributed structures (AD1, AD2, AD3, ...) whose common gate lines are directly or indirectly connected in series so as to form lines of lengths that are programmable with several bits (LLP2, LLP2', LLP3, LLP4).

10. Device according to Claim 5, **characterized in that** the connection between one (202) of the ends of the second line (Lgc1) and one (204) of the ends of the third line (Lgc2) comprises at least a passive delay (RP1 to RP3).

11. Device according to one of Claims 2 to 10, **characterized in that** the switchable active elements comprise field-effect transistors (T), bipolar heterojunction transistors or similar.

12. Device according to any one of Claims 2 to 11, **characterized in that** it is capable of operating over a very wide band of frequencies going from DC up to several tens of GHz.

13. Device according to one of Claims 2 to 12, **characterized in that** it is fabricated using microwave monolithic integrated circuit technology.

## Patentansprüche

1. Doppelter Kettenverstärker, der mindestens eine erste Leitung (Lgc1, Ldc1, 10), von der ein Ende einen gemeinsamen Anschluss für Umschaltmittel (T) bildet, mindestens eine zweite (Ldc1, Lgc1, Ldc1) und eine dritte Leitung (Ldc2, Lgc2, Ldc2), deren Enden die umgeschalteten Anschlüsse für die Umschaltmittel (T) bilden, und zwischen der ersten Leitung und jeder der zwei umgeschalteten Leitungen mindestens ein umschaltbares aktives Element (T) aufweist, wobei das zwischen der ersten Leitung (Lgc1, Ldc1, 10) und der zweiten Leitung (Ldc1, Lgc1, Ldc1) angeordnete umschaltbare aktive Element im Verstärkermodus polarisiert ist, wenn das zwischen der ersten Leitung (Lgc1, Ldc1, 10) und der dritten Leitung (Ldc2, Lgc2, Ldc2) angeordnete umschaltbare aktive Element sperrend polarisiert ist und umgekehrt, wobei der doppelte Kettenverstärker so die Funktion der aktiven Umschaltung gewährleistet, **dadurch gekennzeichnet, dass** eines der Enden der zweiten Leitung (Ldc1, Ldg1, Ldc1) und eines der Enden der dritten Leitung (Ldc2, Ldg2, Ldc2) beide mit einem Summierglied verbunden sind, wobei der doppelte Kettenverstärker eine Leitung mit auf 1 Bit programmierbarer Länge bildet.

2. Phasenregelvorrichtung mit digitaler Steuerung, die einen digitalen Steuereingang und zwischen einem Signaleingang (2) und einem Signalausgang (4) mindestens eine Schaltung aufweist, die Umschaltmittel aufweist, die unter der Steuerung durch ein Bit des Steuereingangs in der Lage sind, mindestens zwei bezüglich der Phase und/oder der Zeitverzögerung verschiedene Transferfunktionen zu liefern, **dadurch gekennzeichnet, dass** die Schaltung mindestens einen doppelten Kettenverstärker (DAD1, DAD2, LAD) nach Anspruch 1 aufweist, wobei das umschaltbare aktive Element in Abhängigkeit vom Steuerbit der Zelle gesteuert wird.

3. Vorrichtung nach Anspruch 2, **dadurch gekennzeichnet, dass** das Summierglied (18) aktiv ist.

4. Vorrichtung nach Anspruch 2, **dadurch gekennzeichnet, dass** das Summierglied (18) passiv ist.

5. Vorrichtung nach Anspruch 2, **dadurch gekennzeichnet, dass** das Summierglied durch die Reihenschaltung der zweiten und der dritten Leitung (Lgc1, Lgc2) des doppelten Kettenverstärkers gebildet wird, wobei der doppelte Kettenverstärker so eine selbstrekombinierende Struktur bildet.

6. Vorrichtung nach einem der Ansprüche 2 bis 4, **dadurch gekennzeichnet, dass** der doppelte Kettenverstärker (LAD) mindestens eine erste und eine zweite einfache Kettenstruktur (AD1, AD2) aufweist, die je eine gemeinsame Leitung von Gates (Lgc1) und eine gemeinsame Leitung von Drains (Ldc1) aufweisen, wobei eines der Enden der gemeinsamen Leitung von Gates der ersten Struktur (AD1) mit einem der Enden der gemeinsamen Leitung von Gates der zweiten Struktur (AD2) verbunden ist, um die erste Leitung (10) des doppelten Kettenverstärkers (LAD) zu bilden, während die Leitungen von Drains der ersten und der zweiten Kettenstruktur (AD1 und AD2) die zweite bzw. die dritte Leitung des doppelten Kettenverstärkers (LAD) bilden.

7. Vorrichtung nach Anspruch 6, **dadurch gekennzeichnet, dass** sie mindestens zwei doppelte Kettenverstärker (LAD1, LAD2) aufweist, die in Reihe geschaltet werden, um einen vierfachen Kettenverstärker (QAD) mit aktiver Umschaltung zu bilden.

8. Vorrichtung nach Anspruch 6, **dadurch gekennzeichnet, dass** eines der Enden der zweiten Leitung (Ldc1) und eines der Enden der dritten Leitung (Ldc2) beide mit einem passiven oder aktiven Summierglied (18) verbunden sind, dessen Ausgang mit einer Last (21) verbunden ist, wobei d8ie erste und die zweite einfache Kettenstruktur (AD1, AD2) eine Leitung mit auf 1 Bit programmierbarer Länge (LLP1) bilden.

9. Vorrichtung nach Anspruch 8, **dadurch gekennzeichnet, dass** sie mehrere einfache Kettenstrukturen (AD1, AD2, AD3, ...) aufweist, deren gemeinsame Gate-Leitungen direkt oder indirekt in Reihe geschaltet werden, um Leitungen mit programmierbarer Länge (LLP2, LLP2', LLP3, LLP4) von mehreren Bits zu bilden.

10. Vorrichtung nach Anspruch 5, **dadurch gekennzeichnet, dass** die Verbindung zwischen einem (202) der Enden der zweiten Leitung (Lgc1) und einem (204) der Enden der dritten Leitung (Lgc2) mindestens eine passive Verzögerung (RP1 bis RP3) aufweist.

11. Vorrichtung nach einem der Ansprüche 2 bis 10, **dadurch gekennzeichnet, dass** die aktiven umschaltbaren Elemente Feldeffekttransistoren (T), bipolare Transistoren mit Heteroübergang oder ähnliche aufweisen.

12. Vorrichtung nach einem der Ansprüche 2 bis 11, **dadurch gekennzeichnet, dass** sie in einem sehr breiten Frequenzband arbeiten kann, das vom Gleichstrom bis zu mehreren zehn GHz reicht.

13. Vorrichtung nach einem der Ansprüche 2 bis 12, **dadurch gekennzeichnet, dass** sie in der Technologie der monolithischen integrierten Mikrowellenschaltkreise hergestellt ist.
